(19) Europäisches Patentamt European Patent Office Office européen des brevets

(11) **EP 4 712 346 A1**

(12) **EUROPEAN PATENT APPLICATION**
published in accordance with Art. 153(4) EPC

(43) Date of publication:
**18.03.2026 Bulletin 2026/12**

(21) Application number: **24803307.8**

(22) Date of filing: **01.04.2024**

(51) International Patent Classification (IPC):
*H03H 9/25* (2006.01)    *H10N 30/853* (2023.01)

(52) Cooperative Patent Classification (CPC):
**H03H 9/25; H10N 30/853**

(86) International application number:
**PCT/JP2024/013466**

(87) International publication number:
**WO 2024/232192 (14.11.2024 Gazette 2024/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **09.05.2023 JP 2023077370**

(71) Applicant: **SHIN-ETSU CHEMICAL CO., LTD.
Tokyo 1000005 (JP)**

(72) Inventors:
• **TANNO, Masayuki**
  **Annaka-shi, Gunma 379-0195 (JP)**
• **AKIYAMA, Shoji**
  **Annaka-shi, Gunma 379-0195 (JP)**
• **SASAKI, Hirokazu**
  **Annaka-shi, Gunma 379-0195 (JP)**

(74) Representative: **Vossius & Partner
Patentanwälte Rechtsanwälte mbB
Siebertstraße 3
81675 München (DE)**

(54) **COMPOSITE SUBSTRATE FOR SURFACE ACOUSTIC WAVE DEVICES**

(57) Provided is a composite substrate for surface acoustic wave devices, the composite substrate including a piezoelectric single crystal thin film, a support substrate, and at least one intervening layer that is provided between the piezoelectric single crystal thin film and the support substrate, the intervening layer being in contact with the piezoelectric single crystal thin film, the total thickness of the intervening layer being equal to or less than twice the wavelength of the surface acoustic wave, and the attenuation of a longitudinal wave of the intervening layer as calculated by a Brillouin oscillation method at a frequency of 40 GHz to 60 GHz being $8 \times 10^{-2}$ ($nm^{-1} \cdot THz^{-2}$) or less. According to the present invention, it is possible to provide a composite substrate for surface acoustic wave devices, which has a small loss in the pass band of a filter, few spurious components, and excellent high performance and high reliability.

Fig. 4

Wavelength of acoustic wave (= 18 $\mu$m)

$SiO_{1.7}$ thin film
(2.82 $\mu$m thick)

Si substrate (100) orientation

EP 4 712 346 A1

## EP 4 712 346 A1

### Description

Technical Field

The present invention relates to a composite substrate for surface acoustic wave devices, which is composed of a piezoelectric single crystal thin film and a support substrate.

Background Art

In mobile phones and other devices, surface acoustic wave (SAW) devices are used as frequency adjustment and selection components, with comb electrodes (IDT: Inter Digital Transducer) formed on a piezoelectric substrate to excite surface acoustic waves. Surface acoustic wave devices are required to be small, have low insertion loss, and not allow unwanted waves to pass through, and piezoelectric materials such as lithium tantalate ($LiTaO_3$; LT) and lithium niobate ($LiNbO_3$; LN) are used for surface acoustic wave devices.

On the other hand, under the communication standards for fourth generation and later mobile phones, the piezoelectric materials used in surface acoustic wave devices need to have sufficiently small temperature-induced characteristic variations. In order to prevent unnecessary noise from spilling out between bands, filters, duplexers, and multiplexers are required to have as small an insertion loss as possible, and the shoulder characteristics of the filter need to be extremely steep, and resonators that make up the filter are required to have a high Q value (Quality Factor). In addition, filters are required to be compatible with a wide bandwidth depending on the band used.

Regarding materials used in such surface acoustic wave devices, composite substrates made of piezoelectric materials and other materials are being considered. For example, PTL 1 discloses an acoustic wave device having a piezoelectric film, the acoustic wave device including a support substrate, a high sound velocity film formed on the support substrate and having a propagating bulk wave sound velocity higher than the acoustic wave velocity propagating through the piezoelectric film, a low sound velocity film laminated on the high sound velocity film and having a propagating bulk wave sound velocity lower than the bulk wave sound velocity propagating through the piezoelectric film, the piezoelectric film laminated on the low sound velocity film, and an IDT electrode formed on one side of the piezoelectric film.

Furthermore, PTL 2 discloses an acoustic wave device including a support substrate, a medium layer laminated on the support substrate, a piezoelectric body laminated on the medium layer and through which bulk waves propagate, and an IDT electrode formed on one side of the piezoelectric body, the medium layer including a low velocity medium in which the propagation velocity of a bulk wave, which is the same as the bulk wave that is a main component of the acoustic wave, is lower than the sound velocity of the acoustic waves propagating through the piezoelectric body, and a high velocity medium in which the propagation velocity of a bulk wave, which is the same as the bulk wave that is the main component of the acoustic wave, is higher than the sound velocity of the acoustic waves propagating through the piezoelectric body, the medium layer being formed such that, when the sound velocity of a main vibration mode in the case of forming the medium layer in the high velocity medium is VH and the sound velocity of a main vibration mode in the case of forming the medium layer in the low velocity medium is VL, the sound velocity of the main vibration mode in the acoustic wave device in which the medium layer is formed satisfies VL < sound velocity of the main vibration mode < VH, and the medium layer having a thickness of 1 λ or more, where λ is the period of the IDT.

Citation List

Patent Literature

   PTL 1:JP 5713025 B

   PTL 2:JP 5861789 B

Summary of Invention

Technical Problem

However, when a surface acoustic wave filter is made using the composite substrate of PTL 1 or PTL 2, the energy of the acoustic wave leaks from the piezoelectric body into and remains in the low velocity medium, causing a problem that noise called spurious or ripple occurs within the pass band of the surface acoustic wave filter or at higher frequencies. The noise is caused by wave reflection at an interface between a piezoelectric crystal film and the support substrate, or by trapping of acoustic waves in an intervening layer between the piezoelectric crystal film and the support substrate, and is undesirable because it deteriorates the frequency characteristics of the surface acoustic wave filter and causes an increase in loss in the pass band of the filter.

The present invention has been made in view of the above circumstances, and an object thereof is to provide a composite substrate for surface acoustic wave devices, which has a small loss in the pass band of a filter, few spurious components, and excellent high performance and high reliability.

Solution to Problem

As a result of intensive research, the inventors of the present invention have found that by providing a piezoelectric single crystal thin film, a support substrate, and at least one intervening layer between the piezoelectric single crystal thin film and the support substrate, and by specifying the total thickness of the intervening layer and the attenuation of longitudinal waves, the loss in the pass band of the filter can be reduced and high reliability can be obtained, and have completed the present invention. The gist of the present invention is as follows.

[1] A composite substrate for surface acoustic wave devices, the composite substrate including a piezoelectric single crystal thin film, a support substrate, and at least one intervening layer that is provided between the piezoelectric single crystal thin film and the support substrate, the intervening layer being in contact with the piezoelectric single crystal thin film, the intervening layer having a total thickness equal to or less than twice a wavelength of the surface acoustic wave, and an attenuation of a longitudinal wave of the intervening layer as calculated by a Brillouin oscillation method at a frequency of 40 GHz to 60 GHz being $8 \times 10^{-2}$ ($nm^{-1} \cdot THz^{-2}$) or less.

[2] The composite substrate for surface acoustic wave devices according to [1], in which transverse waves of the intervening layer has a sound velocity higher than that of slow transverse waves of the piezoelectric single crystal thin film.

[3] The composite substrate for surface acoustic wave devices according to [1] or [2], in which the piezoelectric single crystal thin film contains 120 ppm or less of iron, and the piezoelectric single crystal thin film has a volume resistivity of $2 \times 10^{11}$ $\Omega \cdot cm$ or less.

[4] The composite substrate for surface acoustic wave devices according to any one of [1] to [3], in which the intervening layer is either $SiO_x$ ($1.8 < x < 2.05$) or $SiO_yN_z$ ($0.02 < z/(y + z) < 0.1$).

[5] The composite substrate for surface acoustic wave devices according to any one of [1] to [4], in which the piezoelectric single crystal thin film has a main component of lithium tantalate or lithium niobate.

[6] The composite substrate for surface acoustic wave devices according to any one of [1] to [5], in which the support substrate is any one of a silicon substrate, a sapphire substrate, an alumina substrate, a silicon carbide substrate, an aluminum nitride substrate, a silicon nitride substrate, and a quartz substrate.

[7] The composite substrate for surface acoustic wave devices according to any one of [1] to [5], in which the support substrate is made of a single crystal Si and a polysilicon layer formed on the single crystal Si.

[8] The composite substrate for surface acoustic wave devices according to any one of [1] to [7], in which Li ions in the intervening layer has a content of $1 \times 10^{17}$ $atom/cm^3$ or less.

Advantageous Effects of Invention

According to the present invention, it is possible to provide a composite substrate for surface acoustic wave devices, which has a small loss in the pass band of a filter and high reliability.

Brief Description of Drawings

[Fig. 1] Fig. 1 is a diagram showing an example of a spectrum of Brillouin oscillations of a $SiO_{1.7}$ thin film.
[Fig. 2] Fig. 2 is a diagram showing a waveform obtained by Fourier transforming only reflected light of ultrasonic waves (longitudinal waves) in a thin film.
[Fig. 3] Fig. 3 is a diagram showing a relationship of dependency between an LSAW sound velocity of a thin film and a value of the thin film thickness normalized by the wavelength of the ultrasonic wave (thin film thickness/wavelength), and a calculation result of the sound velocity of an acoustic wave obtained by a finite element method.
[Fig. 4] Fig. 4 is a diagram showing an example of a calculation result of the displacement distribution of a wave in which the energy of an acoustic wave is concentrated on a surface layer of a thin film of a $SiO_{1.7}$ thin film/(111)Si substrate structure.
[Fig. 5] Fig. 5 is a diagram showing an example of a cross-sectional TEM observation photograph of a composite substrate produced in Example 1.
[Fig. 6] Fig. 6 is a diagram showing a composite substrate having an Al microelectrode formed on the surface.
[Fig. 7] Fig. 7 is a diagram showing a resonant waveform (input impedance (Zin) and Q value) of SAW obtained in Example 1.
[Fig. 8] Fig. 8 is a diagram showing a resonant waveform (input impedance (Zin) and Q value) of SAW obtained in Example 2.
[Fig. 9] Fig. 9 is a diagram showing a resonant waveform (input impedance (Zin) and Q value) of SAW obtained in Comparative Example 1.
[Fig. 10] Fig. 10 is a diagram showing a resonant waveform (input impedance (Zin) and Q value) of SAW obtained in Comparative Example 2.

Description of Embodiments

Hereinafter, a composite substrate for surface acoustic wave devices of the present invention will be described in detail; however, the present invention is not limited to the embodiment. In addition, a numerical range defined by using the expression "X to Y" includes numerical values at both ends (upper limit and lower limit) of "X to Y".

[Composite Substrate for Surface Acoustic Wave Devices]

The composite substrate for surface acoustic wave devices of the present invention is a composite substrate including a piezoelectric single crystal thin film, a support substrate, and at least one intervening layer that is provided between the piezoelectric single crystal thin film and the support substrate, the intervening layer being in contact with the piezoelectric single crystal thin film, the total thickness of the intervening layer being equal to or less than twice the wavelength of the surface acoustic wave, and the attenuation of a longitudinal wave of the intervening layer as calculated by a Brillouin oscillation method at a frequency of 40 GHz to 60 GHz being $8 \times 10^{-2}$ (nm$^{-1}$·THz$^{-2}$) or less.

(Piezoelectric single crystal thin film)

The piezoelectric single crystal thin film in the composite substrate for surface acoustic wave devices in one embodiment of the present invention is not particularly limited as long as it can be used as a piezoelectric film; however, it is preferable that the main component is lithium tantalate (LiTaO$_3$:LT) or lithium niobate (LiNbO$_3$:LN). By using the above-mentioned components as the main components of the piezoelectric single crystal thin film, an acoustic wave device with large electromechanical coupling can be obtained.
In the present invention, that the main component of the piezoelectric single crystal thin film is lithium tantalate or lithium niobate means that 50% by mass or more of the components constituting the piezoelectric single crystal thin film are lithium tantalate or lithium niobate. In addition, the piezoelectric single crystal thin film may contain iron, magnesium, etc., as components other than lithium tantalate and lithium niobate.
Further, it is preferable that the piezoelectric single crystal thin film contains 120 ppm or less of iron. By containing a small amount of iron in the piezoelectric single crystal thin film, an electric field at which the polarization of the piezoelectric single crystal thin film is destroyed, that is, a coercive electric field, increases, making it difficult for the polarization to be destroyed. From the above viewpoint, the content of iron is more preferably 10 ppm or more and 120 ppm or less, and even more preferably 50 ppm or more and 100 ppm or less.
In addition, it is preferable that the initial volume resistivity of the piezoelectric single crystal thin film is $2 \times 10^{11}$ $\Omega$·cm or less. By having the initial volume resistivity of the piezoelectric single crystal thin film of $2 \times 10^{11}$ $\Omega$·cm or less, the constant temperature resistance of the composite substrate for surface acoustic wave devices of the present invention can be improved. The initial volume resistivity of the piezoelectric single crystal thin film is more preferably $2 \times 10^{10}$ $\Omega$·cm or more and $2 \times 10^{11}$ $\Omega$·cm or less, and even more preferably $2 \times 10^{10}$ $\Omega$·cm or more and $1 \times 10^{11}$ $\Omega$·cm or less.

(Support substrate)

In one embodiment of the present invention, the support substrate in the composite substrate for surface acoustic wave devices can be any one of a silicon substrate, a sapphire substrate, an alumina substrate, a silicon carbide substrate, an aluminum nitride substrate, a silicon nitride substrate, and a quartz substrate.
A surface acoustic wave resonator produced using a composite substrate for surface acoustic wave devices using the above substrate as the support substrate can provide a surface acoustic wave device with a high Q value, further suppression of out-of-band spurious, and excellent temperature characteristics.
Further, the support substrate may be made of a single crystal Si and a polysilicon layer formed on the single crystal Si.

By appropriately adjusting the thickness of the polysilicon layer of the support substrate, it is possible to further suppress out-of-band spurious.

The thickness of the polysilicon layer is preferably 0.2 $\mu$m or more and 2 $\mu$m or less, more preferably 0.5 $\mu$m or more and 1.9 $\mu$m or less, and still more preferably 0.5 $\mu$m or more and 1.2 $\mu$m or less.

(Intervening layer)

The composite substrate for surface acoustic wave devices of the present invention includes an intervening layer between the piezoelectric single crystal thin film and the support substrate, and the intervening layer is provided in contact with the piezoelectric single crystal thin film. In one embodiment of the present invention, the intervening layer in the surface acoustic wave device composite substrate is either $SiO_x$ (1.8 < x < 2.05) or $SiO_yN_z$ (0.02 < z/(y + z) < 0.1).

Furthermore, the composite substrate for surface acoustic wave devices of the present invention includes at least one intervening layer. The intervening layer may be one layer or two or more layers, and when there are two or more layers, each layer may be made of the same material or different materials.

The content of Li ions in the intervening layer is preferably $1 \times 10^{17}$ atom/cm$^3$ or less. Li ions mainly diffuse from the piezoelectric single crystal thin film to the intervening layer; and by setting the Li ion content in the intervening layer to $1 \times 10^{17}$ atom/cm$^3$ or less, softening of the intervening layer can be prevented and in-band and out-of-band spurious can be suppressed.

Furthermore, the thickness of the intervening layer is the thickness of the intervening layer when there is one layer of the intervening layer, and when there are two or more layers of the intervening layer, the total thickness is equal to or less than twice the wavelength of the surface acoustic wave of the intervening layer. When the thickness of the intervening layer exceeds twice the wavelength of the surface acoustic wave of the intervening layer, the acoustic wave is easily trapped in the intervening layer, resulting in a problem of increased out-of-band spurious. The total thickness of the intervening layer is preferably equal to or less than twice the wavelength of the surface acoustic wave, and more preferably equal to or less than the wavelength of the surface acoustic wave.

Furthermore, the attenuation of the longitudinal waves in the intervening layer calculated at a frequency of 40 GHz to 60 GHz by a Brillouin oscillation method is $8 \times 10^{-2}$ (nm$^{-1}\cdot$THz$^{-2}$) or less.

When the acoustic attenuation of the longitudinal waves in the intervening layer is large, the acoustic waves are easily trapped in the intervening layer. In this case, the surface acoustic wave resonator made of the composite substrate for surface acoustic wave devices of the present invention has a problem of large out-of-band spurious. By setting the attenuation of the longitudinal waves of the intervening layer to $8 \times 10^{-2}$ (nm$^{-1}\cdot$THz$^{-2}$) or less, the Q value of the surface acoustic wave resonator is high, and out-of-band spurious can be further suppressed. The attenuation of the longitudinal waves of the intervening layer is preferably $2 \times 10^{-2}$ (nm$^{-1}\cdot$THz$^{-2}$) or less, and more preferably $0.5 \times 10^{-2}$ (nm$^{-1}\cdot$THz$^{-2}$) or less.

In addition, the sound velocity of the transverse waves of the intervening layer is preferably higher than the sound velocity of the slow transverse waves of the piezoelectric single crystal thin film. By making the velocity of the transverse waves (bulk waves) of the intervening layer higher than that of the slow transverse waves (bulk waves) of the piezoelectric single crystal thin film, the loss in the pass band of the surface acoustic wave filter obtained using the composite substrate for surface acoustic wave devices can be improved. When the velocity of the transverse waves in the intervening layer is lower than the slow transverse waves in the piezoelectric single crystal thin film, there is a concern that the acoustic waves may be easily trapped in the intervening layer. Since the piezoelectric single crystal thin film is an anisotropic material, there are two types of transverse waves in the piezoelectric single crystal thin film, i.e., fast transverse waves and slow transverse waves.

For example, in LiTaO$_3$ as an example of the piezoelectric single crystal thin film, the slow transverse wave of 46° rotated Y-cut LiTaO$_3$ is 3330 m/s. In addition, in SiO$_{1.85}$ or SiO$_{1.94}$N$_{0.06}$ as an example of the intervening layer, the sound velocity of the transverse wave of SiO$_{1.85}$ or SiO$_{1.94}$N$_{0.06}$ is high, at 3850 m/s and 3750 m/s, respectively. The sound velocity of the transverse waves in SiO$_{1.85}$ or SiO$_{1.94}$N$_{0.06}$ will be described in detail later; however, it can be determined from a measured transverse wave sound velocity of the LSAW of the piezoelectric single crystal thin film using a linear convergent beam ultrasonic microscope and analysis using the finite element method, as described in, for example, Tatsuya Omori[1], Kensuke Sakamoto, Satoshi Suzuki, Jun-ichi Kushibiki, Satoru Matsuda, and Ken-ya Hashimoto, "Characterization of Elastic Properties of SiO2 Thin Films by Ultrasonic Microscopy".

By using SiO$_{1.85}$ or SiO$_{1.94}$N$_{0.06}$ for the intervening layer and LiTaO$_3$ for the piezoelectric single crystal thin film, the sound velocity of the transverse waves in the intervening layer can be made higher than the sound velocity of the slow transverse waves in the piezoelectric single crystal thin film.

In addition, when obtaining the attenuation of the longitudinal waves of the intervening layer calculated at a frequency of 40 GHz to 60 GHz by the Brillouin oscillation method, the attenuation was $1.2 \times 10^{-2}$ (nm$^{-1}\cdot$THz$^{-2}$) for SiO$_{1.85}$ and $0.1 \times 10^{-2}$ (nm$^{-1}\cdot$THz$^{-2}$) for SiO$_{1.94}$N$_{0.06}$, and the attenuation of the longitudinal waves can be set to $8 \times 10^{-2}$ (nm$^{-1}\cdot$THz$^{-2}$) or less.

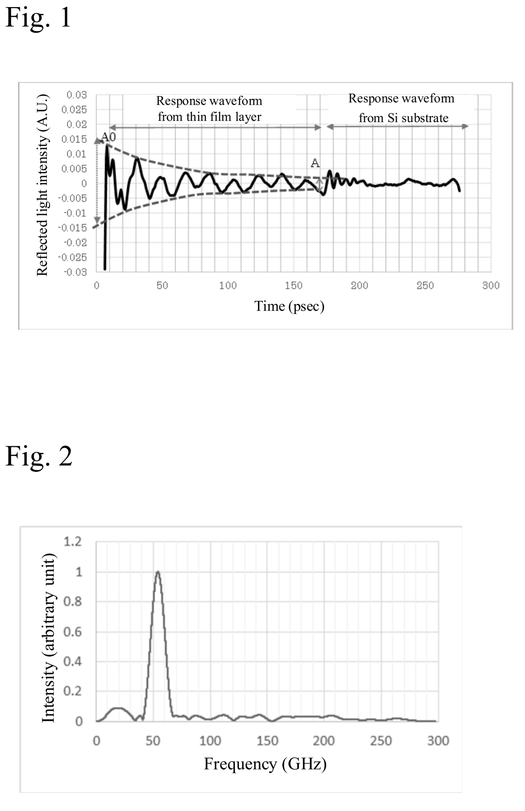

Here, a method described in H.Ogi et.al, "Elastic constant and Brillouin oscillations in sputtered vitreous SiO2 thin films", PHISICAL REVIEW B 78,13204 (2008) can be used as the Brillouin oscillation method. Fig. 1 shows an example of the spectrum of Brillouin oscillations of a $SiO_{1.7}$ thin film having the same composition and production method as the intervening layer, when the composition of the intervening layer is $SiO_{1.7}$.

The $SiO_{1.7}$ thin film (hereinafter, simply referred to as "thin film") used in the measurement of Fig. 1 was formed on a Si substrate with a thickness of 1055 nm (the thickness is d) of $SiO_{1.7}$ thin film of the same composition and production method as the intervening layer, and an Al film of 10 nm was further formed on the $SiO_{1.7}$ thin film. The production method of the thin film is not particularly limited, and may be, for example, a CVD method. Ultrahigh frequency ultrasonic waves are generated by irradiating a structure consisting of the Al film, $SiO_{1.7}$ thin film, and Si substrate with extremely short pulse light. Further, delayed pulse light with a reference wavelength ($\lambda$) of 400 nm is irradiated. The longitudinal wave sound velocity of the thin film can be obtained by detecting the light diffracted by the ultrasonic waves in the thin film.

At this time, the density of the thin film and the refractive index at 400 nm are obtained in advance. The refractive index (n) of the thin film at 400 nm was 1.728 using a prism coupler method.

The density ($\rho$) of the thin film determined by XPS (X-ray photoelectron spectroscopy) was 2300 kg/m$^3$. The first half of the Brillouin spectrum shown in Fig. 1 shows the reflected light intensity due to diffraction by ultrasonic waves (longitudinal waves) in the thin film. By Fourier transforming only the reflected light of ultrasonic waves (longitudinal waves) in the thin film, the frequency of the ultrasonic waves (longitudinal waves) in the thin film shown in Fig. 2 can be obtained. From Fig. 2, the frequency (f) of the ultrasonic waves (longitudinal waves) in the thin film can be calculated to be 54.5 GHz.

At this time, the sound velocity vl of the ultrasonic waves (longitudinal waves) in the thin film can be calculated using the following Formula (1).

$$vl = f \times \lambda/(2 \times n) \ ... \ \text{Formula (1)}$$

The sound velocity of the ultrasonic waves (longitudinal waves) in the thin film shown in Fig. 2, calculated using Formula (1), was 6325 m/s. The elastic constant C11 of the thin film can be calculated using $vl = \sqrt{C11/\rho}$, and the elastic constant C11 of the thin film was 92 GPa.

Next, description will be made to how to determine the sound velocity of transverse waves in a $SiO_{1.7}$ film using the linear convergent beam ultrasonic microscope and the finite element method.

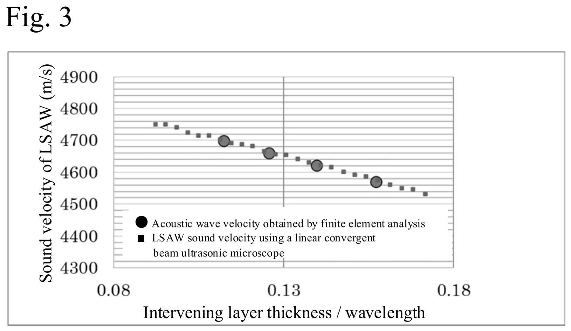

First, for example, by using a linear convergent beam ultrasonic microscope as described in the above-mentioned Tatsuya Omori1, Kensuke Sakamoto, Satoshi Suzuki, Jun-ichi Kushibiki, Satoru Matsuda, and Ken-ya Hashimoto, "Characterization of Elastic Properties of SiO2 Thin Films by Ultrasonic Microscopy", the LSAW sound velocity of the thin film was measured by varying the frequency from 160 MHz to 275 MHz to obtain the dependency of the value of the thin film thickness normalized by the wavelength of the ultrasonic wave (thin film thickness/wavelength). The relationship diagram is shown in Fig. 3.

The LSAW sound velocity (vertical axis) measured by the linear convergent beam ultrasonic microscope in Fig. 3 was obtained by forming a $SiO_{1.7}$ thin film having a thickness of 2830 nm with the same composition and production method as the intervening layer on a substrate with a Si (111) orientation, and propagating the LSAW to the surface layer of the $SiO_{1.7}$ thin film/Si substrate structure through pure water as a couplant such that the linear convergent beam of the linear convergent beam ultrasonic microscope was shifted 45 degrees clockwise from the (110) direction in the Si substrate plane when viewed from the thin film side.

On the other hand, using the two-dimensional finite element method, a ZnO film and an Al electrode, sufficiently thin compared to the electrode period, were placed on the surface layer of the thin film of the $SiO_{1.7}$ thin film/(111) Si substrate structure, and an acoustic wave was excited in a direction shifted 45 degrees clockwise from the <110> direction of the Si of the thin film-attached Si substrate, and the wavelength determined by the electrode period was varied on the finite element method calculation model to calculate the relationship between the acoustic wave velocity of the $SiO_{1.7}$ thin film/(111) Si substrate structure and the intervening layer normalized by the wavelength. At this time, since the elastic constant C12 of the $SiO_{1.7}$ thin film is an unknown quantity, a provisional value was input for C12, and C12 was determined so as to match the measurement result of the LSAW sound velocity using the linear convergent beam ultrasonic microscope in Fig. 3. For the other constants (C11, $\rho$), the values mentioned above were used to calculate..

The value of C12 obtained above was 20 GPa. Furthermore, the calculation results of the acoustic velocity of acoustic waves using the finite element method when the elastic constant C12 of the $SiO_{1.7}$ thin film is 20 GPa are shown in Fig. 3.

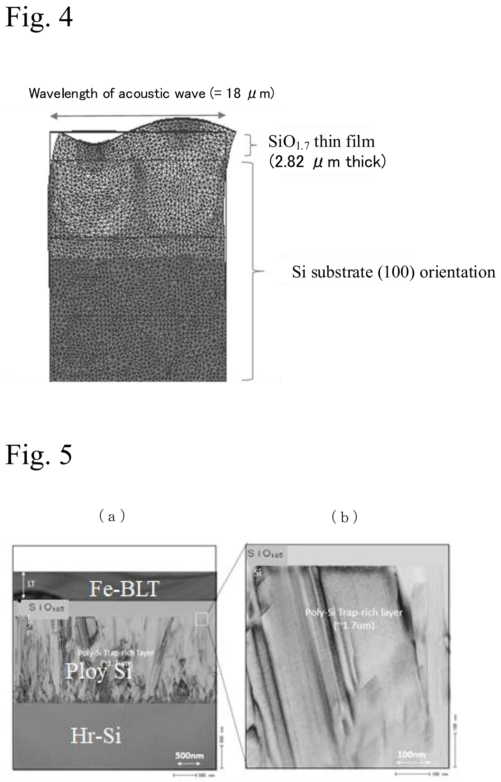

As an example, in a calculation model using the finite element method when the acoustic wave wavelength is 18 $\mu$m, the calculation result of the displacement distribution of a wave in which the energy of the acoustic wave is concentrated on the surface layer of the thin film of the $SiO_{1.7}$ thin film/(111)Si substrate structure is shown in Fig. 4.

From the above study, the transverse wave sound velocity Vs ($= \sqrt{(C11 - C12)/\rho}$) of the $SiO_{1.7}$ thin film alone was calculated, and as a result, Vs = 3960 m/s was obtained. In the calculation model using the finite element method of the present application, the elastic constants of the Si substrate, ZnO film, and Al film were taken from the values given in the Surface Acoustic Wave Data Book (edited by the Electronic Industries Association of Japan (zaidanhoujin nihon denshi kougyou kougyoukai)), (p. 66 (ZnO), p. 165 (Si), p. 172 (Al)).

In addition, in the study of the present application, as a unique attempt, the present application focused on the fact that the reflected light intensity due to diffraction by ultrasonic waves (longitudinal waves) in the thin film layer, which is the first half of the Brillouin spectrum shown in Fig. 1, attenuates exponentially over time. That is, in the envelope of the reflected light intensity shown by the dotted line in Fig. 1, in a case where the amplitude intensity at 0 psec is A0 and the amplitude intensity at the time when the ultrasonic waves reach Si is A, the attenuation constant ($\beta$) of ultrasonic waves (longitudinal waves) in the thin film is described by Formula (2).

$$A = A0 \exp (-\beta \cdot f^2 \cdot d) \text{ ... Formula (2)}$$

In the case of Fig. 2, A0 was 0.03 and A was 0.004. From the above, the attenuation constant $\beta$ is calculated from Formula (3).

$$\beta = -1/(f^2 \cdot d) \cdot \ln (A/A0) \text{ ... Formula (3)}$$

In the case of Fig. 2, $\beta$ was $10.8 \times 10^{-2}$ ($nm^{-1} \cdot THz^{-2}$).

For the various intervening layers described above, the attenuation of longitudinal waves was calculated at frequencies of 40 GHz to 60 GHz using the Brillouin oscillation method in the same manner as above.

When the acoustic attenuation of the longitudinal waves in the intervening layer is large, the acoustic waves are easily trapped in the intervening layer. In this case, it was confirmed that the surface acoustic wave resonator made of the composite substrate for surface acoustic wave devices has a problem of large out-of-band spurious.

On the other hand, when the intervening layer according to the present invention has a high acoustic velocity and little attenuation of longitudinal waves, the acoustic waves cannot be concentrated excessively in the intervening layer, and the wave energy can be concentrated in the piezoelectric single crystal thin film. Therefore, the surface acoustic wave resonator using the composite substrate for surface acoustic wave devices of the present invention has a high Q value, and out-of-band spurious is further suppressed, which is preferable.

Examples

Hereinafter, the present invention will be described in more detail with reference to Examples, but the present invention is not limited thereto.

(Example 1)

A polysilicon layer of 1.7 $\mu$m was formed on the surface layer of a (111) oriented high-resistance silicon substrate with a diameter of 150 nm.

Then, a melt with a composition in which the amount of lithium was reduced based on the amount of lithium contained in a lithium tantalate crystal of a congruent composition was prepared, and an iron-substituted lithium tantalate crystal was grown from the melt with the adjusted composition.

A 6-inch iron-containing 42° Y-cut lithium tantalate (LT) substrate was prepared by adjusting the amount of added iron such that the iron content in the iron-substituted lithium tantalate crystal was 95 ppm by mass. The volume resistivity of the iron-containing 42° Y-cut lithium tantalate (LT) substrate was adjusted to $2.2 \times 10^{10}$ $\Omega \cdot$cm by reduction treatment.

Then, hydrogen molecular ions were implanted into the 6-inch iron-containing lithium tantalate (LT) substrate from a surface to be bonded. The dose at this time was $9 \times 10^{16}$ $atm/cm^2$, and the acceleration voltage was 160 KeV.

Next, a 0.4 $\mu$m thick intervening layer with a composition of $SiO_{1.85}$ was formed by CVD method on the ion-implanted surface of the 6-inch iron-containing lithium tantalate (LT) substrate into which hydrogen molecular ions had been implanted.

Then, the silicon substrate on which the polysilicon layer was formed and the iron-containing LT substrate having the 0.4 $\mu$m thick intervening layer using $SiO_{1.85}$ were subjected to surface activation treatment by plasma treatment. Furthermore, the silicon substrate on which the polysilicon layer was formed and the iron-containing LT substrate were bonded together with the 0.4 $\mu$m thick intervening layer using $SiO_{1.85}$ interposed therebetween to form a bonded body.

Next, the bonded body was subjected to heat treatment at 350°C under nitrogen to prevent the introduction of crystal defects due to misalignment of the bonding interface. Then, the heat-treated bonded body was heated to 110°C, and a wedge was driven into one end of the ion-implanted portion of the iron-containing lithium tantalate (LT) substrate to separate it into the iron-containing lithium tantalate (LT) piezoelectric single crystal thin film layer bonded to the silicon substrate and the remaining iron-containing lithium tantalate (LT) substrate.

The thickness of the iron-containing lithium tantalate (LT) piezoelectric single crystal thin film layer bonded to the silicon substrate after separation was measured with a spectrophotometer and found to be 0.52 $\mu$m. Next, the composite substrate consisting of the iron-containing lithium tantalate (LT) piezoelectric single crystal thin film layer bonded to the silicon substrate was heated at 500°C for 6 hours.

Furthermore, the surface layer of the iron-containing lithium tantalate (LT) piezoelectric single crystal thin film of the composite substrate was polished by 20 nm, and the thickness of the iron-containing lithium tantalate (LT) piezoelectric single crystal thin film layer bonded to the silicon substrate was measured with a spectrophotometer, and found to be 0.5 $\mu$m.

Fig. 5 is a diagram showing an example of a cross-sectional TEM observation photograph of the composite substrate of Example 1 produced by the above method, and Fig. 5 (b) is a photograph with a part of Fig. 5 (a) further enlarged.

The amount of Li in the intervening layer ($SiO_{1.85}$ layer) of the composite substrate produced by the above method was measured by secondary ion mass spectrometry (SIMS), and the maximum amount of Li in the $SiO_{1.85}$ layer was $2 \times 10^{16}$ atom/$cm^3$. The composition ratio of the intervening layer ($SiO_{1.85}$ layer) was determined by X-ray photoelectron spectroscopy (XPS).

Furthermore, the density of the intervening layer ($SiO_{1.85}$ layer) was determined by XPS (X-ray photoelectron spectroscopy) and was found to be 2240 g/$cm^3$. The longitudinal wave sound velocity and attenuation of the intervening layer ($SiO_{1.85}$ layer) were determined by the Brillouin oscillation method. As a result, the longitudinal wave sound velocity of the intervening layer ($SiO_{1.85}$ layer) was 6200 m/s, and the sound attenuation rate was $1.2 \times 10^{-3}$ (nm$^{-1}$·THz$^{-2}$) at 55 GHz.

The transverse wave sound velocity of the intervening layer ($SiO_{1.85}$ layer) alone was determined by combining the linear convergent beam ultrasonic microscope and finite element analysis, and was found to be 3850 m/s.

Next, an Al film was sputtered to a thickness of 0.14 $\mu$m onto the surface of the composite substrate obtained above, a resist was applied, and then a resist pattern with a line width of approximately 0.5 $\mu$m was formed by i-line exposure. The Al was then etched by dry etching to form a first layer of a one-port SAW resonator. At this time, the wavelength of the surface acoustic wave was 2 $\mu$m, and the thickness of the intervening layer ($SiO_{1.85}$ layer) was 0.2 wavelengths.

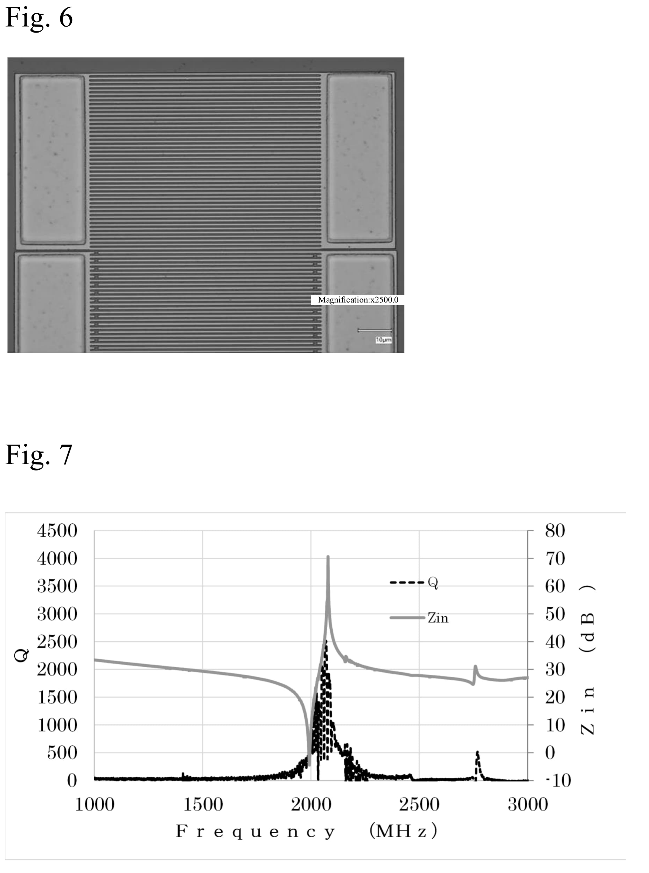

Furthermore, a second layer of pads having an Al film thickness of 0.6 $\mu$m was formed on the composite substrate by a lift-off method. Fig. 6 shows a composite substrate having an Al microelectrode formed on the surface.

Next, the electrical characteristics of the one-port SAW resonator on the iron-containing lithium tantalate (LT) piezoelectric single crystal thin film substrate bonded to the silicon substrate created above were measured using a network analyzer. The resulting resonant waveform (input impedance (Zin) and Q value) of SAW is shown in Fig. 7.

Table 1 shows the resonance frequency (fr), anti-resonance frequency (fa), electromechanical coupling coefficient ($k^2$), maximum Q value (Qmax), input impedance amplitude ($\Delta Z$), fractional bandwidth (fractional bandwidth = (anti-resonance frequency - resonance frequency) / resonance frequency), and spurious intensity of 2400 to 2800 MHz of the SAW resonator.

[Table 1]

| Resonance frequency (fr) | Anti-resonance frequency (fa) | Electromechanical coupling coefficient ($k^2$) | Maximum value of Q (Qmax) | Amplitude of input impedance ($\Delta Z$) | Fractional bandwidth | Maximum spurious intensity at 2400 to 2800MHz |
|---|---|---|---|---|---|---|
| MHz | MHz | % | | (db) | % | (db) |
| 1992.9 | 2079.1 | 9.8 | 2522.4 | 75.0 | 4.3 | 6.4 |

Next, the iron-containing lithium tantalate (LT) piezoelectric single crystal thin film substrate bonded to the silicon substrate with the one-port SAW resonator pattern created above was placed on a hot plate heated to 350°C for 10 minutes, then placed on a cooling plate at room temperature to cool, and the electrical characteristics of the one-port SAW resonator were measured again using the network analyzer. The resulting characteristics were the same as those in Table 1. Furthermore, the 350°C hot plate heating, cooling and measurement were repeated for a cumulative time of 4 hours in total for 350°C hot plate heating, and the electrical characteristics of the one-port SAW resonator after each cumulative time of heating were not different from those in Table 1.

(Example 2)

A composite substrate consisting of an iron-containing lithium tantalate (LT) piezoelectric single crystal thin film bonded to a silicon substrate was prepared in the same manner as in Example 1, except that a 0.3 $\mu$m thick intervening layer having a composition of $SiO_{1.94}N_{0.06}$ was used instead of the 0.4 $\mu$m thick intervening layer having a composition of $SiO_{1.85}$ used in Example 1.

The amount of Li in the intervening layer ($SiO_{1.94}N_{0.06}$ layer) of the iron-containing lithium tantalate (LT) piezoelectric single crystal thin film substrate bonded to the silicon substrate was measured by secondary ion mass spectrometry (SIMS), and the amount of Li in the $SiO_{1.94}N_{0.06}$ layer was $1 \times 10^{14}$ atom/cm$^3$ or less. The composition ratio of the intervening layer ($SiO_{1.94}N_{0.06}$ layer) was determined by X-ray photoelectron spectroscopy (XPS).

In addition, the LT layer of the composite substrate consisting of the iron-containing lithium tantalate (LT) piezoelectric single crystal thin film bonded to the silicon substrate was removed, and the density of the intervening layer ($SiO_{1.94}N_{0.06}$ layer) was determined by X-ray reflectivity measurement (XRR). As a result, the density of the intervening layer ($SiO_{1.94}N_{0.06}$ layer) was 2210 g/cm$^3$. In addition, the LT layer of the iron-containing lithium tantalate (LT) piezoelectric single crystal thin film substrate bonded to the silicon substrate was removed, and the longitudinal wave sound velocity and attenuation of the intervening layer ($SiO_{1.94}N_{0.06}$ layer) were determined by the Brillouin oscillation method. As a result, the longitudinal wave sound velocity of the intervening layer ($SiO_{1.94}N_{0.06}$ layer) was 6190 m/s, and the sound attenuation rate was $1.2 \times 10^{-3}$ (nm$^{-1} \cdot$THz$^{-2}$) at 55 GHz.

The transverse wave sound velocity of the $SiO_{1.94}N_{0.06}$ layer alone, which is the intervening layer, was determined by combining the linear convergent beam ultrasonic microscope and finite element analysis, and was found to be 3750 m/s.

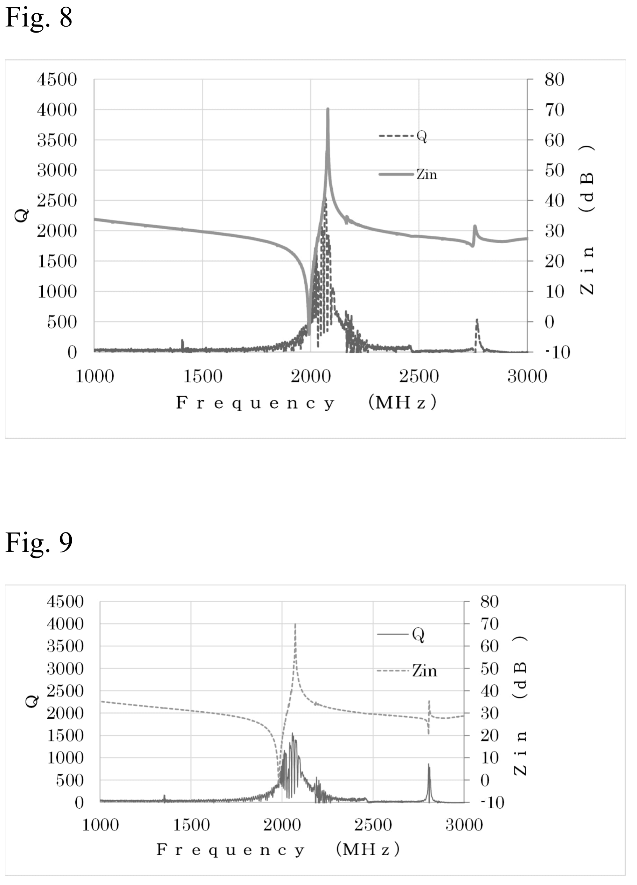

Next, the electrical characteristics of the one-port SAW resonator on the iron-containing lithium tantalate (LT) piezoelectric single crystal thin film substrate bonded to the silicon substrate created above were measured using a network analyzer. The resulting resonant waveform (input impedance (Zin) and Q value) of SAW is shown in Fig. 8. At this time, the wavelength of the surface acoustic wave was 2 $\mu$m, and the thickness of the intervening layer ($SiO_{1.94}N_{0.06}$ layer) was 0.15 wavelengths.

Table 1 shows the resonance frequency (fr), anti-resonance frequency (fa), electromechanical coupling coefficient ($k^2$), maximum Q value (Qmax), input impedance amplitude ($\Delta Z$), fractional bandwidth, and spurious intensity of 2400 to 2800 MHz of the SAW resonator.

[Table 2]

| Resonance frequency (fr) | Anti-resonance frequency (fa) | Electromechanical coupling coefficient ($k^2$) | Maximum value of Q (Qmax) | Amplitude of input impedance ($\Delta Z$) | Fractional bandwidth | Maximum spurious intensity at 2400 to 2800MHz |
|---|---|---|---|---|---|---|
| MHz | MHz | % | | (db) | % | (db) |
| 1992.9 | 2079.1 | 9.8 | 2631 | 74.5 | 4.3 | 6.7 |

Next, the iron-containing lithium tantalate (LT) piezoelectric single crystal thin film substrate bonded to the silicon substrate with the one-port SAW resonator pattern created in the same manner as in Example 1 was placed on a hot plate heated to 350°C for 10 minutes, then placed on a cooling plate at room temperature to cool, and the electrical characteristics of the one-port SAW resonator were measured again using the network analyzer. The resulting characteristics were the same as those in Table 2. Furthermore, the 350°C hot plate heating, cooling and measurement were repeated for a cumulative time of 4 hours in total for 350°C hot plate heating, and the electrical characteristics of the one-port SAW resonator after each cumulative time of heating were not different from those in Table 2.

(Comparative Example 1)

A polysilicon layer of 1.7 $\mu$m was formed on the surface layer of a (111) oriented high-resistance silicon substrate with a diameter of 150 nm.

Then, a melt with a composition in which the amount of lithium was reduced based on the amount of lithium contained in a lithium tantalate crystal of a congruent composition was prepared, and an iron-substituted lithium tantalate crystal was grown from the melt with the adjusted composition.

A 6-inch iron-containing 42° Y-cut lithium tantalate (LT) substrate was prepared by adding iron in an amount such that the iron content in the iron-substituted lithium tantalate crystal was 95 ppm by mass. The volume resistivity of the iron-containing 42° Y-cut lithium tantalate (LT) substrate was adjusted to $2.2 \times 10^{10}$ Ω·cm by reduction treatment.

Then, hydrogen molecular ions were implanted into the 6-inch iron-containing lithium tantalate (LT) substrate from a surface to be bonded. The dose at this time was $9 \times 10^{16}$ atm/cm$^2$, and the acceleration voltage was 160 KeV.

Next, a 0.4 μm thick intervening layer with a composition of $SiO_{1.7}$ was formed by CVD method on the ion-implanted surface of the 6-inch iron-containing lithium tantalate (LT) substrate into which hydrogen molecular ions had been implanted.

Then, the silicon substrate on which the polysilicon layer was formed and the iron-containing LT substrate having the 0.4 μm thick intervening layer using $SiO_{1.7}$ were subjected to surface activation treatment by plasma treatment. Furthermore, the silicon substrate on which the polysilicon layer was formed and the iron-containing LT substrate were bonded together with the 0.4 μm thick intervening layer using $SiO_{1.7}$ interposed therebetween to form a bonded body.

Next, the bonded body was subjected to heat treatment at 350°C under nitrogen to prevent the introduction of crystal defects due to misalignment of the bonding interface. Then, the heat-treated bonded body was heated to 110°C, and a wedge was driven into one end of the ion-implanted portion of the iron-containing lithium tantalate (LT) substrate to separate it into the iron-containing lithium tantalate (LT) piezoelectric single crystal thin film layer bonded to the support substrate and the remaining iron-containing lithium tantalate (LT) substrate.

The thickness of the iron-containing lithium tantalate (LT) piezoelectric single crystal thin film layer bonded to the silicon substrate after separation was measured with a spectrophotometer and found to be 0.52 μm. Next, the composite substrate consisting of the iron-containing lithium tantalate (LT) piezoelectric single crystal thin film bonded to the silicon substrate was heated at 500°C for 6 hours.

Furthermore, the surface layer of the iron-containing lithium tantalate (LT) piezoelectric single crystal thin film of the composite substrate was polished by 20 nm, and the thickness of the iron-containing lithium tantalate (LT) piezoelectric single crystal thin film layer bonded to the silicon substrate was measured with a spectrophotometer, and found to be 0.5 μm.

The amount of Li in the intervening layer ($SiO_{1.7}$ layer) of the composite substrate produced by the above method was measured by secondary ion mass spectrometry (SIMS), and the maximum amount of Li in the $SiO_{1.7}$ layer was $2 \times 10^{17}$ atom/cm$^3$. The composition ratio of the intervening layer ($SiO_{1.7}$ layer) was determined by X-ray photoelectron spectroscopy (XPS).

Furthermore, the density of the intervening layer ($SiO_{1.7}$ layer) was determined by XPS (X-ray photoelectron spectroscopy) and was found to be 2240 g/cm$^3$. The longitudinal wave sound velocity and attenuation of the intervening layer ($SiO_{1.7}$ layer) were determined by the Brillouin oscillation method. As a result, the longitudinal wave sound velocity of the intervening layer ($SiO_{1.7}$ layer) was 6325 m/s, and the sound attenuation rate was $10.8 \times 10^{-2}$ (nm$^{-1}$·THz$^{-2}$) at 55 GHz.

The transverse wave sound velocity of the intervening layer ($SiO_{1.7}$ layer) alone was determined by combining the linear convergent beam ultrasonic microscope and finite element analysis, and was found to be 3960 m/s.

Next, an Al film was sputtered to a thickness of 0.14 μm onto the surface of the composite substrate obtained above, a resist was applied, and then a resist pattern with a line width of approximately 0.5 μm was formed by i-line exposure. The Al was then etched by dry etching to form a first layer of a one-port SAW resonator.

Furthermore, a second layer of pads having an Al film thickness of 0.6 μm was formed on the composite substrate by a lift-off method. At this time, the wavelength of the surface acoustic wave was 2 μm, and the thickness of the intervening layer ($SiO_{1.7}$ layer) was 0.2 wavelengths.

Next, the electrical characteristics of the one-port SAW resonator on the iron-containing lithium tantalate (LT) piezoelectric single crystal thin film substrate bonded to the silicon substrate created above were measured using a network analyzer. The resulting resonant waveform (input impedance (Zin) and Q value) of SAW is shown in Fig. 9.

Table 3 shows the resonance frequency (fr), anti-resonance frequency (fa), electromechanical coupling coefficient ($k^2$), maximum Q value (Qmax), input impedance amplitude ($\Delta Z$), fractional bandwidth, and spurious intensity of 2400 to 2800 MHz of the SAW resonator.

[Table 3]

| Resonance frequency (fr) | Anti-resonance frequency (fa) | Electromechanical coupling coefficient ($k^2$) | Maximum value of Q (Qmax) | Amplitude of input impedance ($\Delta Z$) | Fractional bandwidth | Maximum spurious intensity at 2400 to 2800MHz |
|---|---|---|---|---|---|---|
| MHz | MHz | % | | (db) | % | (db) |
| 1983.0 | 2072.5 | 10.2 | 1556.4 | 72.2 | 4.5 | 16 |

Next, the iron-containing lithium tantalate (LT) piezoelectric single crystal thin film substrate bonded to the silicon substrate with the one-port SAW resonator pattern created above was placed on a hot plate heated to 350°C for 10 minutes, then placed on a cooling plate at room temperature to cool, and the electrical characteristics of the one-port SAW resonator were measured again using the network analyzer. The resulting characteristics were the same as those in Table 3. Furthermore, the 350°C hot plate heating, cooling and measurement were repeated for a cumulative time of 4 hours in total for 350°C hot plate heating, and the electrical characteristics of the one-port SAW resonator after each cumulative time of heating were not different from those in Table 3.

(Comparative Example 2)

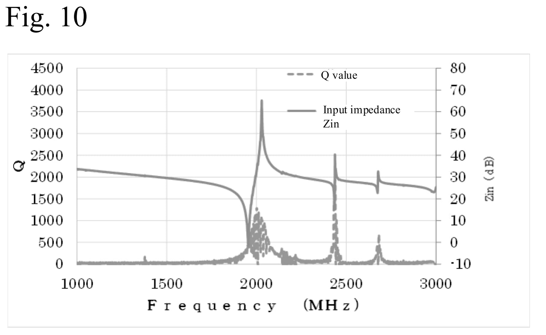

A polysilicon layer of 1.7 $\mu$m was formed on the surface layer of a high-resistance silicon substrate with a diameter of 150 nm.
Next, an iron-free lithium tantalate crystal was grown on a lithium tantalate crystal of a congruent composition.
A 6-inch iron-free 42° Y-cut lithium tantalate (LT) substrate was prepared by processing the iron-free lithium tantalate crystal. The volume resistivity of the iron-free 42° Y-cut lithium tantalate (LT) substrate was adjusted to $2.2 \times 10^{10}$ $\Omega \cdot$cm by reduction treatment.
Then, hydrogen molecular ions were implanted into the 6-inch iron-free lithium tantalate (LT) substrate from a surface to be bonded. The dose at this time was $9 \times 10^{16}$ atm/cm$^2$, and the acceleration voltage was 160 KeV.
Next, a 0.4 $\mu$m thick intervening layer with a composition of $SiO_2$ was formed by CVD method on the ion-implanted surface of the 6-inch iron-free lithium tantalate (LT) substrate.
Then, the silicon substrate on which the polysilicon layer was formed and the iron-free LT substrate having the 0.4 $\mu$m thick intervening layer using $SiO_2$ were subjected to surface activation treatment by plasma treatment. Furthermore, the silicon substrate on which the polysilicon layer was formed and the iron-free LT substrate were bonded together with the 0.4 $\mu$m thick intervening layer using $SiO_2$ interposed therebetween to form a bonded body.
Next, the surface of the bonded body (bonded substrate) was removed by grinding and polishing.
The thickness of the iron-free lithium tantalate (LT) piezoelectric single crystal thin film layer bonded to the silicon substrate after thinning was measured with a spectrophotometer and found to be 0.5 $\mu$m.
The amount of Li in the intervening layer ($SiO_2$ layer) of the composite substrate produced by the above method was measured by secondary ion mass spectrometry (SIMS), and the maximum amount of Li in the $SiO_2$ layer was $5 \times 10^{19}$ atom/cm$^3$. The composition ratio of the intervening layer ($SiO_2$ layer) was determined by X-ray photoelectron spectroscopy (XPS).
In addition, the LT layer of the composite substrate produced by the above method was removed, and the density of the intervening layer ($SiO_2$ layer) was determined by X-ray reflectivity measurement (XRR). As a result, the density of the intervening layer ($SiO_2$ layer) was 2100 g/cm$^3$. The LT layer of the composite substrate was removed, and the longitudinal wave sound velocity and attenuation of the intervening layer ($SiO_2$ layer) were determined by the Brillouin oscillation method. As a result, the longitudinal wave sound velocity of the intervening layer ($SiO_2$ layer) was 5400 m/s, and the sound attenuation rate was $5 \times 10^{-1}$ (nm$^{-1}\cdot$THz$^{-2}$) at 55 GHz.
The transverse wave sound velocity of the $SiO_2$ layer alone, which is the intervening layer, was determined by combining the linear convergent beam ultrasonic microscope and finite element analysis, and was found to be 3150 m/s.
Next, the electrical characteristics of the one-port SAW resonator on the iron-free lithium tantalate (LT) piezoelectric single crystal thin film substrate bonded to the silicon substrate created above were measured using a network analyzer. The resulting resonant waveform (input impedance (Zin) and Q value) of SAW is shown in Fig. 10.
Table 4 shows the resonance frequency (fr), anti-resonance frequency (fa), electromechanical coupling coefficient ($k^2$), maximum Q value (Qmax), input impedance amplitude ($\Delta Z$), fractional bandwidth, and spurious intensity of 2400 to 2800 MHz of the SAW resonator. At this time, the wavelength of the surface acoustic wave was 2 $\mu$m, and the thickness of the intervening layer ($SiO_2$ layer) was 0.2 wavelengths.

[Table 4]

| Resonance frequency (fr) | Anti-resonance frequency (fa) | Electromechanical coupling coefficient ($k^2$) | Maximum value of Q (Qmax) | Amplitude of input impedance ($\Delta Z$) | Fractional bandwidth | Maximum spurious intensity at 2400 to 2800MHz |
|---|---|---|---|---|---|---|
| MHz | MHz | % | | (db) | % | (db) |
| 1954.6 | 2029.2 | 8.7 | 1260 | 65 | 3.8 | 21 |

Next, the iron-free lithium tantalate (LT) piezoelectric single crystal thin film substrate bonded to the silicon substrate with the one-port SAW resonator pattern created above was placed on a hot plate heated to 350°C for 10 minutes, then placed on a cooling plate at room temperature to cool, and the electrical characteristics of the one-port SAW resonator were measured again using the network analyzer. The resulting characteristics were the same as those in Table 4. Furthermore, the 350°C hot plate heating, cooling and measurement were repeated for a cumulative time of 4 hours in total for 350°C hot plate heating, and when the cumulative heating time reached about 1 hour, the electromechanical coupling coefficient ($k^2$) began to decrease from the value in Table 3, and after the cumulative heating time reached 4 hours, the electromechanical coupling coefficient ($k^2$) had decreased to 5%.

## Claims

1.  A composite substrate for surface acoustic wave devices, the composite substrate comprising a piezoelectric single crystal thin film, a support substrate, and at least one intervening layer that is provided between the piezoelectric single crystal thin film and the support substrate,
    the intervening layer being in contact with the piezoelectric single crystal thin film, the intervening layer having a total thickness equal to or less than twice a wavelength of the surface acoustic wave, and an attenuation of a longitudinal wave of the intervening layer as calculated by a Brillouin oscillation method at a frequency of 40 GHz to 60 GHz being $8 \times 10^{-2}$ ($nm^{-1} \cdot THz^{-2}$) or less.

2.  The composite substrate for surface acoustic wave devices according to claim 1, wherein transverse waves of the intervening layer has a sound velocity higher than that of slow transverse waves of the piezoelectric single crystal thin film.

3.  The composite substrate for surface acoustic wave devices according to claim 1 or 2, wherein the piezoelectric single crystal thin film contains 120 ppm or less of iron, and
    the piezoelectric single crystal thin film has a volume resistivity of $2 \times 10^{11}$ $\Omega \cdot cm$ or less.

4.  The composite substrate for surface acoustic wave devices according to claim 1 or 2, wherein the intervening layer is either SiOx ($1.8 < x < 2.05$) or SiOyNz ($0.02 < z/(y + z) < 0.1$).

5.  The composite substrate for surface acoustic wave devices according to claim 1 or 2, wherein the piezoelectric single crystal thin film has a main component of lithium tantalate or lithium niobate.

6.  The composite substrate for surface acoustic wave devices according to claim 1 or 2, wherein the support substrate is any one of a silicon substrate, a sapphire substrate, an alumina substrate, a silicon carbide substrate, an aluminum nitride substrate, a silicon nitride substrate, and a quartz substrate.

7.  The composite substrate for surface acoustic wave devices according to claim 1 or 2, wherein the support substrate is made of a single crystal Si and a polysilicon layer formed on the single crystal Si.

8.  The composite substrate for surface acoustic wave devices according to claim 1 or 2, wherein Li ions in the intervening layer has a content of $1 \times 10^{17}$ $atom/cm^3$ or less.

# Fig. 1

# Fig. 2

Fig. 3

Fig. 4

Wavelength of acoustic wave (= 18 $\mu$m)

SiO$_{1.7}$ thin film
(2.82 $\mu$m thick)

Si substrate (100) orientation

Fig. 5

（a）

（b）

Fig. 6

Magnification:x2500.0

10μm

Fig. 7

Fig. 8

Fig. 9

Fig. 10

## INTERNATIONAL SEARCH REPORT

| International application No. |
|---|
| **PCT/JP2024/013466** |

**A.    CLASSIFICATION OF SUBJECT MATTER**

*H03H 9/25*(2006.01)i; *H10N 30/853*(2023.01)i
FI:    H03H9/25 C; H10N30/853

According to International Patent Classification (IPC) or to both national classification and IPC

**B.    FIELDS SEARCHED**

Minimum documentation searched (classification system followed by classification symbols)

H03H9/25; H10N30/853

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2021-180465 A (SHIN ETSU CHEM. CO., LTD.) 18 November 2021 (2021-11-18) entire text, all drawings | 1-8 |
| A | JP 2021-5785 A (SHIN ETSU CHEM. CO., LTD.) 14 January 2021 (2021-01-14) entire text, all drawings | 1-8 |
| A | CN 113872557 A (BEIJING CHAOCAI INFORMATION TECHNOLOGY CO., LTD.) 31 December 2021 (2021-12-31) entire text, all drawings | 1-8 |

☐ Further documents are listed in the continuation of Box C.    ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "D"  document cited by the applicant in the international application | "X"  document of particular relevance; the claimed invention cannot be considered novel or cannot be considered to involve an inventive step when the document is taken alone |
| "E"  earlier application or patent but published on or after the international filing date | |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| **06 June 2024** | **18 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

### INTERNATIONAL SEARCH REPORT
Information on patent family members

International application No.

**PCT/JP2024/013466**

| Patent document cited in search report | | | Publication date (day/month/year) | Patent family member(s) | | | Publication date (day/month/year) |
|---|---|---|---|---|---|---|---|
| JP | 2021-180465 | A | 18 November 2021 | US | 2021/0359660 | A1 | |
| | | | | entire text, all drawings | | | |
| | | | | EP | 3920417 | A2 | |
| | | | | KR | 10-2021-0141345 | A | |
| | | | | CN | 113676147 | A | |
| JP | 2021-5785 | A | 14 January 2021 | US | 2020/0412326 | A1 | |
| | | | | entire text, all drawings | | | |
| | | | | US | 2023/0370043 | A1 | |
| | | | | CN | 112152587 | A | |
| CN | 113872557 | A | 31 December 2021 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5713025 B

- JP 5861789 B

**Non-patent literature cited in the description**

- **TATSUYA OMORI1** ; **KENSUKE SAKAMOTO** ; **SATOSHI SUZUKI** ; **JUN-ICHI KUSHIBIKI** ; **SA-TORU MATSUDA** ; **KEN-YA HASHIMOTO**. *Characterization of Elastic Properties of SiO2 Thin Films by Ultrasonic Microscopy*

- **H.OGI**. Elastic constant and Brillouin oscillations in sputtered vitreous SiO2 thin films. *PHISICAL REVIEW B*, 2008, vol. 78, 13204